# EUROPEAN PATENT APPLICATION

(11) **EP 4 635 922 A1**
(43) Date of publication of application: **22.10.2025**
(21) Application number: 23903455.6
(22) Date of filing: 11.12.2023
(51) Int. Cl.: C03C 17/34, B32B 9/00, B60J 1/00, C03C 17/36, C23C 14/10, C23C 14/34

(54) **GLASS ARTICLE AND METHOD FOR PRODUCING SAME**

(30) Priority: 14.12.2022 JP 2022199456; 13.02.2023 JP 2023019959
(71) Applicant: AGC INC., Chiyoda-ku, Tokyo 1008405 (JP); AGC Glass Europe, 1348 Louvain-La-Neuve (BE)
(72) Inventor: USUI, Reo, Tokyo 100-8405 (JP); KAWAMOTO, Yasushi, Tokyo 100-8405 (JP); FUJIMOTO, Hiroki, Tokyo 100-8405 (JP); HAYASHI, Kazuyuki, Tokyo 100-8405 (JP); TSUKIYAMA, Rika, Tokyo 100-8405 (JP); HEVESI, Kadosa, 1348 Louvain-la-Neuve (BE)
(74) Representative: Müller-Boré & Partner Patentanwälte PartG mbB
(86) International application number: PCT/JP2023/044131
(87) International publication number: WO 2024/128169

(57) **Abstract**

A glass article having an excellent external appearance and capable of suppressing the occurrence of whitening after being subjected to heating and molding, and a method for manufacturing such a glass article are provided. A glass article according to the present disclosure comprises, on a glass substrate (1), a functional layer (3) and a silicon oxide-containing layer (4) in this order, wherein a total amount of Ar in the silicon oxide-containing layer (4) is 52.0 nm·atomic% or less. The glass article may comprise a dielectric layer (2) between the glass substrate (1) and the functional layer (3), and comprise a shielding layer (5) on the silicon oxide-containing layer (4). The glass article can be used as a window glass for automobile. Further, a method for manufacturing a glass article according to the present disclosure comprises forming, on a glass substrate (1), a functional layer (3) and a silicon oxide-containing layer (4) in this order by dry coating, wherein a total amount of Ar in the silicon oxide-containing layer 4 is adjusted to 52.0 nm·atomic% or less.

## Description

### Technical Field

The present disclosure relates to a glass article and a method for manufacturing the same.

### Background Art

In glass articles, such as window glasses for vehicles and those for buildings, desired characteristics are imparted to them by coating the surfaces of their glass substrates with various materials according to their uses.

Patent Literature 1 discloses a glass plate including, on a substrate, a thermal radiation reflection coating including a functional layer containing a transparent conductive oxide (TCO) and a SiO₂ layer. Further, Patent Literature 1 discloses that the glass plate having the SiO₂ layer in the uppermost layer is compatible with an opaque masking printed material consisting of black enamel provided in the peripheral area, and provides a good external appearance.

Note that it is known that, like the aforementioned masking printed material, a shielding layer in which a black pigment, glass frit, or the like is added is provided on the peripheral edge of a glass article for vehicle (e.g., a window glass for automobile) for the purpose of, for example, preventing an adhesive from deteriorating due to sunlight and improving the design.

### Citation List

### Patent Literature

Patent Literature 1: International Patent Publication No. WO2016/184732

### Summary of Invention

### Technical Problem

In the glass plate having the structure disclosed in Patent Literature 1, depending on the type of masking printed material, i.e., the type of shielding layer, air bubbles may be formed during a heating-and-molding process and hence voids may be formed in the shielding layer part. As a result, the surface of the glass article may appear whitish (whitened), so that the external appearance may be impaired.

The present disclosure has been made in view of the above-described problem, and an object thereof is to provide a glass article having an excellent external appearance and capable of suppressing the occurrence of whitening after being subjected to heating and molding, and a method for manufacturing such a glass article.

### Solution to Problem

A glass article according to the present disclosure comprises, on a glass substrate, a functional layer and a silicon oxide-containing layer in this order, wherein a total amount of Ar in the silicon oxide-containing layer is 52.0 nm·atomic% or less.

In the above-described glass article, the total amount of Ar in the silicon oxide-containing layer may be 19.0 nm·atomic% or less.

In any one of the above-described glass articles, a total amount of H in the silicon oxide-containing layer may be 5.7×10²³ nm/cm³ or less.

In any one of the above-described glass articles, the total amount of H in the silicon oxide-containing layer may be 2.9×10²³ nm/cm³ or less.

Any one of the above-described glass articles may further comprise a shielding layer on the silicon oxide-containing layer, and a Bi/Si ratio in the shielding layer may be 3.8 or lower.

In any one of the above-described glass articles, a content of SiO₂ in the shielding layer may be 15 mass% or more.

In any one of the above-described glass articles, the silicon oxide-containing layer may contain an element selected from Al and Zr.

Any one of the above-described glass articles may comprise a dielectric layer between the glass substrate and the functional layer, and the dielectric layer may contain an element selected from Si, C, Ti, Zr, Nb, Zn, Sn and Al, or an oxide, a nitride or an oxynitride of these elements.

In any one of the above-described glass articles, the functional layer may contain an element selected from In, Sn, Al, Ni, Cr, Zr, Ti, Nb, W, Fe and F, or an oxide, a nitride or an oxynitride of these elements.

Any one of the above-described glass articles may be used as a window glass for automobile.

A method for manufacturing a glass article according to the present disclosure comprises forming, on a glass substrate, a functional layer and a silicon oxide-containing layer in this order by dry coating, wherein a total amount of Ar in the silicon oxide-containing layer is adjusted to 52.0 nm·atomic% or less.

In the above-described method for manufacturing a glass article, a power density when the silicon oxide-containing layer is sputtered may be 8.7 W/cm² or higher.

In any one of the above-described methods for manufacturing a glass article, a process gas pressure when the silicon oxide-containing layer is sputtered may be 3.0 mTorr or lower.

In any one of the above-described methods for manufacturing a glass article, an average blending ratio of O₂ in a process gas when the silicon oxide-containing layer is sputtered may be 80 vol% or higher.

In any one of the above-described methods for manufacturing a glass article, an average blending ratio of O₂ in a process gas when the silicon oxide-containing layer is sputtered may be 90 vol% or higher.

### Advantageous Effects of Invention

According to the present disclosure, it is possible to provide a glass article having an excellent external appearance and capable of suppressing the occurrence of whitening after being subjected to heating and molding, and a method for manufacturing such a glass article.

### Brief Description of Drawings

Fig. 1A is a schematic cross-sectional view of an embodiment of a glass article according to the present disclosure;
Fig. 1B is a schematic cross-sectional view of an embodiment of a glass article according to the present disclosure;
Fig. 1C is a schematic plan view of an embodiment of a glass article according to the present disclosure;
Fig. 2 is a graph showing profiles of concentrations of various atoms in the depth direction measured by using a Rutherford scattering spectrum analyzer in Example 1;
Fig. 3 is a graph showing a relationship between the secondary ion intensity of an element constituting a sample measured by using a secondary ion mass analyzer and the sputtering time in Example 1;
Fig. 4 is a graph showing a relationship between the secondary ion intensity of an element constituting a sample measured by using a secondary ion mass analyzer and the sputtering time in Example 7; and
Fig. 5 is a graph showing a relationship between the secondary ion intensity of an element constituting a sample measured by using a secondary ion mass analyzer and the sputtering time in Example 6.

### Description of Embodiments

In the specification of the present disclosure, a symbol "- (to)", which indicates a range of numerical values, means that values in front of and behind this symbol are included in the range as lower and upper limit values, respectively.

In numerical ranges described in a stepwise manner in the present specification, the upper or lower limit value of one numerical range may be replaced with the upper or lower limit value of another numerical range described in a stepwise manner. Further, in numerical ranges described in a stepwise manner in the present specification, the upper or lower limit value of a numerical range may be replaced with values shown in Examples.

As described above, when various shielding layers are applied to the glass plate having the structure described in Patent Literature 1, depending on the type of shielding layer, whitening may occur on the surface of the obtained glass plate due to voids formed during the heating-and-molding process.

The inventors of the present disclosure have speculated that whitening that occur due to the heating-and-molding operation (and a subsequent optional cooling operation) are caused by the following facts. That is, in the process of forming a coating film (e.g., a dry coating film), a gas (e.g., a process gas in dry coating: an inert gas such as Ar) contained in the coating film escapes therefrom during the heating. Then, when the material for forming the shielding layer (hereinafter also referred to as the shielding layer forming material) is melted by the heating and molding, the aforementioned gas remains in the vicinity of the interface between the coating film and the shielding layer and/or within the shielding layer, so that voids having various shapes are eventually formed there. Then, light is scattered by the formed voids, so that a phenomenon (whitening) occurs in which when the glass article is observed from the surface on the side on which the shielding layer is not disposed, the glass article appears whitish.

As a result of intense study, the inventors of the present disclosure have found that the occurrence of whitening can be suppressed irrespective of the type of shielding layer by adjusting the total amount of Ar in the silicon oxide-containing layer included in the glass article to a specific range.

Embodiments of glass articles according to the present disclosure (hereinafter, also simply referred to as "the present glass article") will be described hereinafter in detail with reference to the drawings, but the present disclosure is not limited to these embodiments. Further, the present disclosure may be modified as desired without departing from the scope and spirit of the disclosure.

### <Glass Article>

A glass article according to the present disclosure can be suitably used as a glass for vehicle such as automotive, especially as a window glass for automobile, and can be used at a position on any part of the body of the vehicle, including the front, rear, side, and ceiling thereof. Further, a glass article according to the present disclosure can also be used for uses other than uses in vehicles, e.g., for buildings and the like without limitation. Further, it is sufficient if a glass article according to the present disclosure has any of the structures described below in at least a part thereof. For example, the glass article may be used as a single-sheet glass including only one glass substrate, or as a laminated glass including a plurality of glass substrates. The method for manufacturing a glass article according to the present disclosure is not limited to any particular methods. For example, a glass article can be manufactured by a known float method as will be described later.

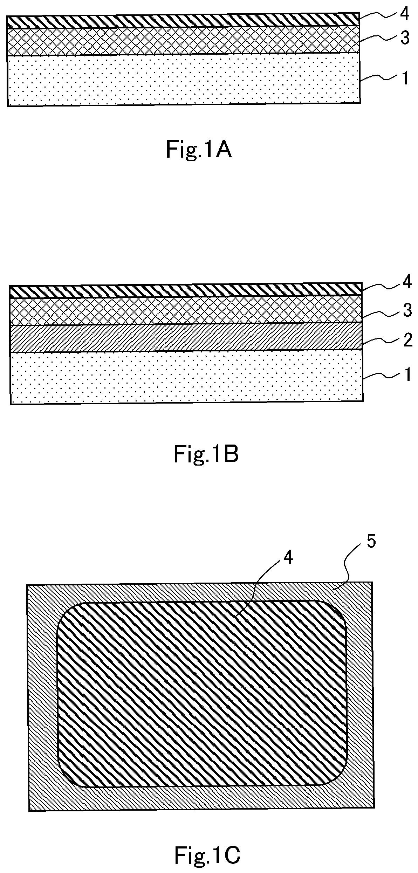

As shown in Fig. 1A, a glass article according to the present disclosure includes, on a glass substrate 1, a functional layer 3 and a silicon oxide-containing layer 4 in this order. Further, as shown in Fig. 1B, the glass article according to the present disclosure may include a dielectric layer 2 between the glass substrate 1 and the functional layer 3. Further, as shown in Fig. 1C, a shielding layer 5 may be provided on at least a part of the silicon oxide-containing layer 4.

In the glass article according to the present disclosure, it is sufficient if these layers are successively laminated on at least a part of one of the surfaces of the glass substrate. That is, these layers may or may not be laminated over the entire surface of the glass substrate of which the glass article is formed. Further, the dielectric layer 2 may be in contact with the glass substrate 1. Alternatively, another layer may be provided between the glass substrate 1 and the dielectric layer 2, so that the glass substrate 1 and the dielectric layer 2 may not be directly in contact with each other. Further, another layer may be provided between the dielectric layer 2 and the functional layer 3, or between the functional layer 3 and the silicon oxide-containing layer 4, so that these layers may not be directly in contact with each other.

For example, a coating film(s) such as the dielectric layer 2, the functional layer 3, and the silicon oxide-containing layer 4 may be provided over the entire surface of the glass substrate, and as shown in Fig. 1C, a frame-shaped shielding layer 5 may be provided, on the coating film(s), in a part that becomes the peripheral edge of the glass substrate.

Further, other layers may be provided between these layers or on any of these layers as long as the effects of the present disclosure are obtained. For example, a color tone adjustment layer for adjusting the color tone, a heat insulating film layer, a UV-cut film layer, and the like may be provided. In order to improve the anti-whitening property, in the glass article according to the present disclosure, the silicon oxide-containing layer 4 is preferably formed as the uppermost layer of the coating film, and the shielding layer is preferably provided on the silicon oxide-containing layer 4. Further, a sealing layer (not shown) such as a seal lip and/or an adhesive layer (not shown) for fixing other members may be provided on the silicon oxide-containing layer 4 (e.g., on the shielding layer 5 in the case where the shielding layer 5 is provided) through a primer. For these layers and the like, known primers, sealing layers, and adhesive layers can be used as appropriate. Note that an abrasion-resistant layer may be disposed on the silicon oxide-containing layer. The abrasion-resistant layer may be formed of, for example, at least one substance selected from ZrBO, ZrO₂, Ta₂O₅, Al₂O₃, TiO₂, Nb₂O₅, SiN and BN.

Note that Figs. 1A and 1B show schematic cross-sectional views of two embodiments of glass articles according to the present disclosure, and Fig. 1C shows a schematic plan view of these glass articles as viewed from the shielding layer 5 side.

### [Silicon Oxide-containing Layer]

In the glass article according to the present disclosure, the total amount of Ar in the silicon oxide-containing layer is 52.0 nm·atomic% or less (0.52 nm or less). When the total amount of Ar is 52.0 nm·atomic% or less, the amount of Ar in the silicon oxide-containing layer can be kept low, thus making it possible to suppress the occurrence of voids and the whitening of the glass article caused by the Ar, and thereby to provide a glass article having an excellent external appearance irrespective of the type of used shielding layer.

From the same point of view, the total amount of Ar in the silicon oxide-containing layer is more preferably 38.0 nm·atomic% or less (0.38 nm or less), and still more preferably 19.0 nm·atomic% or less (0.19 nm or less).

Note that when the glass article according to the present disclosure includes a plurality of silicon oxide-containing layers (e.g., two layers), the total amount of Ar in these plurality of silicon oxide-containing layers is adjusted so as to fall within the aforementioned range. Further, a specific method for measuring the total amount of Ar in the silicon oxide-containing layer will be described later.

Further, the total amount of Ar in the silicon oxide-containing layer is preferably 5.0 nm·atomic% or more (0.05 nm or more). When the total amount of Ar in the silicon oxide-containing layer is 5.0 nm·atomic% or more, the heat resistance of the glass article according to the present disclosure can be easily prevented from deteriorating, so that the deposition rate of the coating film when the coating film is manufactured can be easily adjusted to an appropriate range. From the same point of view, the total amount of Ar in the silicon oxide-containing layer is more preferably 7.0 nm·atomic% or more (0.07 nm or more).

The glass article including a silicon oxide-containing layer having a specific total amount of Ar as described above according to the present disclosure has an excellent anti-whitening property and an excellent external appearance, and of which the occurrence of whitening caused by voids can be suppressed. Therefore, even when the glass article according to the present disclosure is formed into, for example, a curved shape for use in a vehicle at a high temperature (e.g., 600 to 750°C), it is possible to easily prevent the whitening from occurring.

Further, in the glass article according to the present disclosure, the total amount of H in the silicon oxide-containing layer is preferably 5.7×10²³ nm/cm³ or less (nm·atoms/cm³). When the total amount of H is 5.7×10²³ nm/cm³ or less, the content of water (the amount of H) in the silicon oxide-containing layer can be easily kept low, and in conjunction with this, the amount of Ar trapped in the SiOx structure in the silicon oxide-containing layer can be easily suppressed. As a result, it is possible to suppress the occurrence of voids and the whitening of the glass article caused by the Ar, and thereby to provide a glass article having an excellent external appearance irrespective of the type of used shielding layer.

Further, from the same point of view, the total amount of H in the silicon oxide-containing layer is more preferably 4.0×10²³ nm/cm³ or less, and still more preferably 2.9×10²³ nm/cm³ or less.

Further, the total amount of H in the silicon oxide-containing layer is preferably 1.0×10²³ nm/cm³ or more. When the total amount of H in the silicon oxide-containing layer is 1.0×10²³ nm/cm³ or more, it is possible to easily prevent a large number of restrictions from being included in the manufacturing conditions and to easily prevent the waiting time during the film deposition from becoming longer. Further, from the same point of view, the total amount of H in the silicon oxide-containing layer is more preferably 1.2×10²³ nm/cm³ or more.

In the glass article according to the present disclosure, the silicon oxide-containing layer can be a layer containing silicon oxide (SiOx: e.g., x = 1, 2). Therefore, the silicon oxide-containing layer may be a layer made of pure silicon dioxide (SiO₂) or may contain, as a dopant(s), at least one other element such as aluminum (Al), boron (B), tin (Sn), titanium (Ti), zirconium (Zr), hafnium (Hf), and nitrogen (N). That is, the silicon oxide-containing layer may be formed of one layer, or two or more layers made of a material(s) selected from, for example, SiO₂, SiO₂:Al, SiO₂:B, SiO₂:Sn, SiO₂:Ti, SiO₂:Zr, SiO₂:Hf, and SiO₂:N. More specifically, for example, the silicon oxide-containing layer may include only one SiOx layer on the glass substrate, or may include a SiOx layer and another SiOx layer(s) doped with another element(s) in this order.

Among these, the silicon oxide-containing layer preferably contains an element selected from Al and Zr in order to improve the anti-whitening property. Note that the dopants are not limited to those described above, and other known dopants may be contained as appropriate.

The content of silicon oxide (SiOx) in the silicon oxide-containing layer is not limited to any particular values, but is preferably 85 mass% or more, more preferably 90 mass% or more, and still more preferably 92 mass% or more in order to suppress the formation of voids and thereby to improve the anti-whitening property.

The thickness of the silicon oxide-containing layer is not limited to any particular values, but is preferably 20 nm or larger, more preferably 40 nm or larger, and still more preferably 80 nm or larger in view of the antireflection property and the adhesion property. Further, in view of the anti-whitening property, the thickness of the silicon oxide-containing layer is preferably 150 nm or smaller, more preferably 130 nm or smaller, and still more preferably 110 nm or smaller.

Note that when a plurality of silicon oxide-containing layers are formed, it is preferred that the total thickness of the whole silicon oxide-containing layers falls within the above-described range. For example, when the silicon oxide-containing layer includes a SiOx layer and another SiOx layer doped with another element, the ratio between the thicknesses of these two layers (thickness of SiOx layer: Thickness of doped SiOx layer) is preferably 2:1 to 5:1 and more preferably 3:1 to 4:1 in order to improve the anti-whitening property.

As described above, the silicon oxide-containing layer is provided, above the glass substrate, on the outer surface side of the functional layer. The method for laminating a coating film(s) including the functional layer and the silicon oxide-containing layer, and including the dielectric layer as required on the glass substrate is not limited to any particular methods.

However, in order to make better use of the excellent effects of the present disclosure, the coating film(s) is preferably a dry coating film(s) formed by using dry coating in which a thin film is formed in a vacuum by using a vapor growth method. Examples of dry coating films include a heat-ray reflection coating film, a low-emissivity coating film (Low-E film), a low-reflection coating film, and a p-polarization reflection coating film. Among these, in order to make better use of the excellent effects of the present disclosure, the coating film is more preferably two or more, or three or more layers including a low-emissivity coating film and a p-polarization reflection coating film in which a silicon oxide-containing layer is the uppermost layer, and still more preferably a low-emissivity coating film. As the method for forming these films, known methods can be used as appropriate.

Note that the composition of the coating film can be determined by using energy dispersive X-ray spectroscopy (SEM-EDX). The acceleration voltage in the aforementioned method can be set as appropriate, but in order to perform more accurate measurement, it is preferably 5 to 25 keV and more preferably 15 to 20 keV.

Note that the thickness of each layer of the coating film can be determined by separately forming a single film and measuring its thickness by a sensing pin-type step gauge, or by an optical simulation based on spectroscopic measurement for a laminate, an observation by a transmission electron microscope (TEM) or the like. The acceleration voltage in the TEM observation can be set as appropriate, but in order to carry out more accurate measurement, the acceleration voltage is preferably set to 40 to 1,000 kV and more preferably 60 to 300 kV. For the magnification calibration, for example, a standard sample GaAs/AlAs superlattice certified reference substance (NIMC CRM 5201-a (Product Name)) manufactured by National Institute of Advanced Industrial Science and Technology can be used.

In the glass article according to the present disclosure, other layers may be formed on the silicon oxide-containing layer. However, in order to suppress the whitening of the glass article, when a shielding layer is provided, the shielding layer is preferably formed on the silicon oxide-containing layer, more specifically on the surface of the silicon oxide-containing layer.

### [Dielectric Layer]

A dielectric layer can be disposed on the glass substrate, specifically, between the glass substrate and the functional layer. Note that the dielectric layer can be formed by the above-described dry coating method, and preferably contains, for example, an element selected from Si, C, Ti, Zr, Nb, Zn, Sn and Al, or an oxide, a nitride or an oxynitride of these elements. Further, a plurality of types of these components can be combined with one another. For the dielectric layer, for example, a layer made of Si(Al)N, SiO₂, TiO₂ or ZnO, or a layer obtained by doping any of these layers with a dopant (e.g., Zr) can be used. Further, the dielectric layer may be formed of one layer, or two or more layers.

The thickness of the dielectric layer is not limited to any particular values, but the total thickness of the dielectric layer is preferably 20 to 100 nm, more preferably 30 to 90 nm, and still more preferably 40 to 80 nm in order to impart various excellent properties thereto.

### [Functional Layer]

The functional layer can be formed by the above-described dry coating method, and preferably contains, for example, an element selected from In, Sn, Al, Ni, Cr, Zr, Ti, Nb, W, Fe and F, or an oxide, a nitride or an oxynitride of these elements. Further, a plurality of types of these components can be combined with one another. For the functional layer, for example, a layer made of SnO₂, In₂O₃ (ITO), ZrN, TiN or CrN, or a layer obtained by doping any of these layers with a dopant can be used. Further, the functional layer may be formed of one layer, or two or more layers.

The thickness of the functional layer is not limited to any particular values, but the total thickness of the functional layer is preferably 40 to 200 nm, more preferably 50 to 180 nm, and still more preferably 60 to 160 nm in order to impart various excellent properties thereto.

The total thickness of the coating film including the functional layer and the silicon oxide-containing layer (and including the dielectric layer as required) is not limited to any particular values. However, the total thickness of the coating film is preferably 25 to 500 nm, more preferably 50 to 450 nm, and still more preferably 100 to 400 nm in order to impart various excellent properties thereto.

As described above, the glass article according to the present disclosure can be applied to various dry coating films in which a silicon oxide-containing layer is formed on the surface. Regarding each of the dry coating films, parts other than the silicon oxide-containing layer formed on the surface will be mainly described hereinafter.

For example, the heat-ray reflection coating film can be formed of at least one layer, and can be formed of a plurality of layers (e.g., 10 layers to 18 layers). Specifically, the heat-ray reflection coating film may include a barrier layer in addition to the above-described dielectric layer and functional layer. For example, the heat-ray reflection coating film may be formed in the order of, from the glass substrate side, a first dielectric layer, a functional layer, a barrier layer, and a second dielectric layer (e.g., a silicon oxide-containing layer). Note that the functional layer may be formed of, for example, any of Ag, Au, Cu, Al, Nb, W, Fe and Pt, or a combination thereof. Among them, the functional layer may preferably be formed of any one of Au, Cu, Al and Pt, or a combination thereof. Further, each of the dielectric layer and the barrier layer may be formed of any one of Ti, Zn, Sn, Si, Al and Ni, or a combination thereof. Note that each of the dielectric layer and the barrier layer may be formed of an oxide, nitride, or oxynitride of these elements.

The low-emissivity coating film may be formed of one or more layers and, for example, can be formed of a plurality of layers (e.g., two to six layers). For example, the low-emissivity coating film can be formed in the order of, from the glass substrate side, a first dielectric layer, a functional layer, and a second dielectric layer (e.g., a silicon oxide-containing layer). Note that the functional layer may be formed of, for example, any of, In, Sn, Al, Ni, Cr, Zr, Ti, and F, or a combination thereof. Note that the functional layer may be formed of an oxide, nitride, or oxynitride of these elements. The dielectric layer can be formed of Si, C, Ti, Zr, Nb, Zn, Sn and Al, or a combination thereof. Note that the dielectric layer may be formed of an oxide, nitride, or oxynitride of these elements.

Note that in the case where the functional layer contains a transparent conductive oxide (TCO), it is possible to obtain desired characteristics by adjusting the oxidation level of the low-emissivity coating film when it is formed on the clear glass substrate. Note that the oxidation level can be adjusted as appropriate by adjusting the amount of oxygen added to the film formation gas when the functional layer is formed, and this oxidation level can be set as appropriate according to the desired characteristics. However, in the case where, in particular, an ITO (indium tin oxide) layer is formed as the functional layer by using an indium tin oxide target, it is preferred to add 0.1 to 3.0 vol% of oxygen to Ar, which is the main film formation gas. For example, by forming a low-emissivity coating film on a clear glass substrate having a thickness of 1 to 3 mm by this method and heating the formed coating film in a range of 500 to 700°C for 2 to 10 minutes, it is possible to obtain a glass substrate with a low-emissivity coating film having a visible-light transmittance of 85% or higher and a sheet resistance of 25 Ω/□ or lower. In this case, the dielectric layer may be, for example, an oxynitride layer. By adding a minute amount of oxygen to the film formation gas and adjusting the oxidation level of the transparent conductive oxide film as described above, it is possible to easily adjust various characteristics such as the resistance and the visible-light transmittance of the glass article including the low-emissivity coating film to appropriate ranges.

Further, in the case where the functional layer contains a transparent conductive oxide (TCO), it is possible to, by containing, e.g., mixing, moisture in the film formation gas, easily suppress excessive crystallization and thereby easily suppress of the occurrence of cracking during the heating when the low-emissivity coating film is formed on the clear glass substrate. Note that the amount of moisture to be contained in the film formation gas can be adjusted as appropriate. However, in particular, when an ITO (indium tin oxide) layer is formed as the functional layer by using an indium tin oxide target, it is preferred to satisfy the following condition. That is, it is preferred that moisture is present in the film formation gas in a range in which the H₂O/Ar partial pressure ratio in the film formation gas measured by using a quadrupole mass analyzer is 2.0% or lower. For example, by forming a low-emissivity coating film on a clear glass substrate having a thickness of 1 to 3 mm by this method and heating it in a range of 500 to 700°C for 2 to 10 minutes, a glass substrate with a low-emissivity coating film in which cracking does not occur can be obtained. In this case, the dielectric layer may be, for example, an oxynitride layer. By containing, e.g., mixing, a predetermined amount of other components such as moisture in the film formation gas as described, the occurrence of cracking can be easily suppressed.

The low-reflection coating film can be formed of one or more layers and, for example, can be formed of a plurality of layers (e.g., three layers). For example, in view of the refractive index, the low-reflection coating film may be formed in the order of, from the glass substrate side, a low-refraction layer, a high-refraction layer, and a silicon oxide-containing layer, in the order of a high-refraction layer, a low-refraction layer, a high-refraction layer, and a silicon oxide-containing layer, in the order of a low-refraction layer, a high-refraction layer, a low-refraction layer, a high-refraction layer, and a silicon oxide-containing layer, or in the order of a high-refraction layer, a low-refraction layers, a high-refraction layer, a low-refraction layers, a high-refraction layer, and a silicon oxide-containing layer. In this case, the low and high-refraction layer serve as functional layers. That is, the low-reflection coating film may include a plurality of functional layers. Note that the functional layer closest to the glass substrate side (e.g., the layer immediately above the glass substrate) may be a low-refraction layer or a high-refraction layer. Meanwhile, the functional layer closest to silicon oxide-containing layer side (e.g., the layer immediately below the silicon oxide-containing layer) is preferably a high-refraction layer. More specifically, for example, the low-refraction layer may be formed of Si, and the high-refraction layer may be formed of any of Ti, Nb, Ta and Sn, or a combination thereof. Note that any of these refraction layers may be formed of an oxide, a nitride, or an oxynitride of any of the aforementioned elements.

The p-polarization reflection coating film can be formed of one or more layers and, for example, can be formed of a plurality of layers (e.g., two layers). For example, in view of the refractive index, the p-polarization reflection coating film may be formed in the order of, from the glass substrate side, a high-refraction layer and a low-refraction layer, or in the order of a high-refraction layer, a low-refraction layer, a high-refraction layer, and a low-refraction layer. In this case, the low-refraction layer located on the outermost surface layer is the silicon oxide-containing layer, and the other layers are the functional layers. That is, in the p-polarization reflection coating film, only one functional layer may be provided, or two or more functional layers may be provided. The high-refraction layer may be formed of, for example, Au, Ag, Cu, Al, Zn, Zr, Sn, Nb, Ni, In, Ce, W, Mo, Sb, Cr, B, Y, La, Ta, Bi and Ti, or a combination thereof, or an oxide, a nitride, or an oxynitride of these elements. For example, the high-refraction layer may be made of TiO₂ or made of Zr:TiO₂ containing another element(s) as a dopant(s). Further, the low-refraction layer may be formed of an oxide, a nitride, or an oxynitride of Si, and may contain Al or Zr. However, at least the low-refraction layer on the outermost surface side is the above-described silicon oxide-containing layer.

### [Glass Substrate]

Regarding the glass substrate (glass plate) of the glass article according to the present disclosure, known glass substrates can be used as appropriate. For example, for the glass substrate, a heat ray absorbing glass, a clear glass, a soda lime glass, a quartz glass, a borosilicate glass, an alkali-free glass, a green glass, or a UV green glass can be used. However, when a glass article according to the present disclosure is used as a glass for vehicle, the glass substrate is required to have a visible-light transmittance conforming to the safety standards of the country in which the vehicle is used. Further, when the glass article is used for other purposes, the glass substrate is required to have characteristics required for those purposes.
Therefore, the composition of the glass substrate is preferably adjusted so as to achieve the required characteristics. As the composition of the glass substrate, for example, the below-shown composition can be used, in which the components are shown by mass% based on the oxide. Note that the composition of the glass substrate can be specified by an X-ray fluorescence analysis.
Silica (SiO₂): 70 to 73 mass%,
Alumina (Al₂O₃): 0.6 to 2.4 mass%,
Lime (CaO): 7 to 12 mass%,
Magnesia (MgO): 1.0 to 4.5 mass%,
R₂O: 13 to 15 mass% (R represents an alkali metal such as Na or K), and
Total iron oxide (T-Fe₂O₃) in terms of Fe₂O₃: 0 to 1.5 mass%.

Note that the glass substrate may be substantially transparent, or may be tinted, i.e., colored. Further, a glass substrate that has been subjected to a strengthening process can be used as required. The strengthening process may be a chemical strengthening process or a physical strengthening process (air-cooled strengthening process).

Further, the shape of the glass substrate is not limited to any particular shapes as long as it can be molded to a shape suitable for the desired purpose. For example, the glass substrate may have a rectangular shape. The molded shape of a glass article according to the present disclosure is, for example, a curved shape, and the curved shape is not limited to any particular curved shapes. For example, the glass article may have such a shape that it is curved in the up/down direction on the paper on which Fig. 1A is shown. Note that the glass article according to the present disclosure includes both those in which a glass substrate in which a coating film (and a shielding layer) is provided has not yet been formed and those in which the glass substrate has already been formed into a desired shape. Therefore, the glass substrate included in the present glass article may be, for example, a rectangular glass substrate that has not been molded yet or a glass substrate that has already been molded and has a curved shape. Note that a glass article according to the present disclosure may be formed by, for example, forming a curved surface in a glass substrate by a heating bending process called firing bending when the shielding layer, which is provided as required, is fired. Further, a glass article according to the present disclosure may be formed by forming a shielding layer and the like on a glass substrate, and then separately performing firing bending, or may be formed by forming a shielding layer and the like, performing temporary firing, and then performing firing bending. As described above, the timing of the molding of a glass article according to the present disclosure can be selected as desired.

The thickness of the glass substrate may be set according to the purpose and is not limited to any particular values. For example, when the glass substrate is used for an automobile among various types of vehicles, the thickness of the glass substrate is, for example, 0.2 to 5.0 mm and preferably 0.3 to 3.0 mm.

In the case of a laminated glass, in particular, a laminated glass used for a windshield or a roof glass of an automobile, and is located on the outer side of the vehicle when it is attached to the automobile, the thickness of the glass substrate is preferably 1.1 mm or larger and more preferably 1.8 mm or larger in view of the strength such the tolerance to stone chips. Further, in order to reduce the weight of the laminated glass, the thickness of the glass substrate is preferably 3.0 mm or smaller and more preferably 2.8 mm or smaller. In the case of a laminated glass that is disposed on the inner side of the vehicle when it is attached to the automobile, the thickness of the glass substrate is preferably 0.3 mm or larger in view of the handling ability, and is preferably 2.3 mm or smaller in order to reduce the weight of the laminated glass. Further, the glass article can be suitably used not only as a single-sheet glass but also as a laminated glass. That is, the glass article can be used for various uses. Note that the thickness of two glass substrates used for a laminated glass may be equal to each other or different from each other.

The glass substrate can be manufactured as appropriate by a known method (e.g., a float method, a fusion method, and a rollout method), and the method for manufacturing a glass substrate is not limited to any particular methods. Note that a commercially available product may be used as the glass substrate.

### [Shielding Layer]

The glass article according to the present disclosure may include a shielding layer on the above-described silicon oxide-containing layer.

The shielding layer may be provided on at least a part of one of the surfaces of the glass substrate, more specifically, on at least a part of the coating film. However, when the present glass article is used as a glass article for vehicle, the shielding layer is preferably provided so as to cover the peripheral edge of the glass substrate. The shielding layer prevents the components or the like for mounting the glass article on the body of the vehicle and the terminals of electric components from being visible from the outside of the vehicle. Therefore, the shielding layer may be an opaque shielding layer.

Note that the shielding layer may have various shapes such as a frame shape, a band shape, and a dot shape. In Fig. 1C, a frame-shaped shielding layer 5 is provided on the peripheral edge of the glass substrate, more specifically on the peripheral edge of the silicon oxide-containing layer 4. The shielding layer 5 may be provided, for example, so as to cover a specific area extending from the edge of the glass substrate 1. More specifically, the shielding layer 5 may cover a part at least within 30 mm from the edge (e.g., within 50 mm from the edge) of the glass substrate 1.

The shielding layer may include a crystal component, a pigment, an additive (e.g., a resin), and the like. The components (elements) of which the shielding layer is formed are not limited to any particular components. For example, the components may include the following elements: Si, Bi, O, Fe, Ni, C, B, Al, Li, Na, K, Mg, Ca, Ba, Sr, Zn, Ti, Ce, Zr, Cu, Cr, Mn and Co.

In order to prevent the formation of voids and the occurrence of whitening, it is preferred to adjust the composition of the shielding layer. Specifically, it is preferred to adjust the composition ratio of Si (silicon), which has a function of raising the melting start temperature in the heating and molding, and Bi (bismuth), which has a function of lowering the aforementioned melting start temperature. That is, the Bi/Si ratio (mass% ratio) in the shielding layer is preferably set to 3.8 or lower. When this Bi/Si ratio is 3.8 or lower, the sintering temperature of the components in the shielding layer can be relatively increased, so that a larger amount of gas (Ar) can be removed from the silicon oxide-containing layer before the shielding layer is sintered. As a result, the Ar desorption amount in the silicon oxide-containing layer above 550°C can be suppressed, and hence the formation of voids can be suppressed, thus making it possible to easily obtain a glass article having an excellent external appearance. Further, from the same point of view, the Bi/Si ratio is more preferably 3.7 or lower, still more preferably 3.5 or lower, and particularly preferably 3.3 or lower.

Further, the composition of the shielding layer can be specified by using energy dispersive X-ray spectroscopy (SEM-EDX). The acceleration voltage in the aforementioned method can be set as appropriate, but in order to perform more accurate measurement, it is preferably 5 to 25 keV and more preferably 15 to 20 keV.

The shielding layer (e.g., a black ceramic layer) is a fired layer which can be formed by coating a shielding layer forming material (ceramic paste) on a desired place (e.g., on the peripheral edge) in the glass substrate, more specifically, in a desired place on the coating film, heating the applied shielding layer forming material at a high temperature, and thereby sintering the applied shielding layer forming material. The firing temperature can be set as appropriate. For example, the firing temperature can be set to 500 to 700°C (e.g., 600°C or higher).

The shielding layer forming material which has not been fired yet can include frit (corresponding to the crystal component when the shielding layer is formed), a pigment (e.g., a heat-resistant black pigment), and, if necessary, additives such as an (organic) vehicle for dispersing the pigment, a conductive metal, a reducing agent, a dispersive surfactant, a fluid-type modifier, a fluid-type auxiliary agent, an adhesion promoter, a stabilizer, and a colorant. Note that a commercially available product can also be used as the shielding layer forming material. By forming the shielding layer as a fired layer, the shielding layer is bonded (joined) to the glass substrate.

The aforementioned frit can contain, for example, one or more type(s) of component(s) such as SiO₂, Bi₂O₃, Cr₂O₃, Cs₂O, Na₂O, B₂O₃, ZnO, TiO₂, La₂O₃, Nb₂O₅, MnO₂, CeO₂, MoO₃, WO₃, F, Al₂O₃, BaO, MgO, CaO and K₂O. Note that it is known that frit having a high melting point range has excellent chemical resistance and a relatively low thermal expansion coefficient.

SiO₂ in the frit forms a glass network and is also a crystallized component. Further, it also controls chemical, thermal, and mechanical characteristics of the frit, and has a property of increasing the melting point of the frit. SiO₂ may be contained not only in the form of SiO₂, but also in the form of a composite such as Bi₄Si₃O₁₂. In order to improve the anti-whitening property, the content of SiO₂ in the shielding layer is preferably 15 mass% or more, more preferably 18 mass% or more, and still more preferably 20 mass% or more. Further, in order to maintain the sintering property, the content of SiO₂ in the shielding layer is preferably 30 mass% or less, and more preferably 28 mass% or less.

Meanwhile, Bi₂O₃ in the frit is a component for forming a glass network and has a property of lowering the melting point. In order to improve the anti-whitening property, the content of Bi₂O₃ in the shielding layer is preferably 60 mass% or less, and more preferably 55 mass% or less. Further, in view of the fluidity, the content of Bi₂O₃ in the shielding layer is preferably 30 mass% or more, and still more preferably 35 mass% or more.

When the shielding layer is formed, the frit may or may not have a crystal form different from that before the firing, i.e., the crystal form at the raw material stage (shielding layer forming material). Further, the crystal component in the shielding layer may be formed of one type of frit or may be formed of a plurality of types of frits which are, for example, fused by firing.

Further, the frit may be manufactured by a known method. For example, frit having a desired composition can be manufactured by mixing starting materials according to a desired composition, melting the mixture at a desired temperature for a desired time, and, if necessary, cooling the molten mixture by using water or the like. If necessary, the frit can be pulverized into a desired particle size (e.g., 1 to 8 µm) by a known pulverization technique. Note that a commercially available product may also be used as the frit.

The content of the frit in the shielding layer forming material can be set as appropriate, but in order to obtain satisfactory sintering property, it is preferably 60 mass% or more, more preferably 65 mass% or more, and still more preferably 70 mass% or more. On the other hand, in order to maintain the glass strength, the content of the frit in the shielding layer forming material is preferably 99 mass% or less, more preferably 98 mass% or less, and still more preferably 96 mass% or less.

Note that the content in the shielding layer forming material in the specification of the present application means that the content in the total amount of inorganic components among the components constituting the shielding layer forming material. That is, the contents of organic components are not taken into account. Therefore, the content of the frit in the shielding layer forming material is the amount that is obtained by excluding the contents of filler and the like in the shielding layer forming material.

As the aforementioned pigment, known pigments can be used as appropriate. For example, pigments derived from one or more type(s) of composite inorganic pigment(s) such as corundum-hematite, olivine, priderite, pychlor, rutile, spinel, and the like can be used. As the pigment, for example, a metal oxide pigment (spinel pigment) containing copper (Cu), chromium (Cr), iron (Fe), cobalt (Co), nickel (Ni), manganese (Mn), aluminum (Al), magnesium (Mg), zinc (Zn), zirconium (Zr), niobium (Nb), yttrium (Y), tungsten (W), antimony (Sb), calcium (Ca), or the like can be used. These black spinel pigments can be suitably used in the automotive industry, and other metal oxide pigments that produce other colors can be used as appropriate as pigments in other industries such as the construction industry, the household appliance industry, and the beverage industry.

Note that the spinel structure is a common pigment structure having a general formula AB₂X₄, where X is typically O²⁻ or F⁻ having substantially the same ionic radius. Note that A and B represent a tetrahedral site and an octahedral site, respectively, in an ordinary spinel lattice. The spinel structure can be formed from a number of different elements, including transition elements in Group 1, and hence serves as the structure for many inorganic pigments. Most spinel compounds have a cubic space group, but a distorted spinel structure can have a tetragonal phase and, in some cases, can have an orthorhombic phase.

More specific examples of metal oxide pigments include CuO·CrO₃, CuCr₂O₄, (Co, Fe)(Fe, Cr)₂O₄, MnCr₂O₄, NiMnCrFe, CuCrMnO, and those obtained by modifying these pigments by using modifying agents. Note that properties of a pigment can be determined by the raw material, the synthesis technique and conditions, the post-firing process, and the like. A pigment may be synthesized by a known method, e.g., a method disclosed in Published Japanese Translation of PCT International Publication for Patent Application, No. 2019-509959, or a commercially available product may be used.

A desired pigment may be formed, for example, by chemically combining minute metal oxides or salts containing the target metal, and calcining them. When doing so, the size of the minute metal oxide can be set as appropriate, and is preferably 1 nm to 10 µm, more preferably 10 nm to 1 µm, and still more preferably 50 to 500 nm.

Further, as the pigment, one derived from a rare earth manganese oxide pigment can be used. For example, (YxMn)Oy, (LaxMn)Oy, (CexMn)Oy, (PrxMn)Oy, or (NdxMn)Oy can be used. Note that in the above-shown chemical formula, x is preferably 0.01 to 99, more preferably 0.08 to 12, and still more preferably 0.25 to 4. Further, in the above-shown chemical formula, y represents the number of oxygen atoms required to maintain the electrical neutrality, and is preferably x+1 to 2x+2. Specific examples of pigments include CeMnO₃, PrMnO₃, NdMnO₃, and pigments obtained by modifying these pigments by using a modifying agent. Note that the rare earth manganese oxide pigment preferably has a perovskite crystal structure or an orthorhombic crystal structure. By using a rare earth manganese oxide pigment, a high infrared reflectance can be achieved, and the heat generation characteristic can be lowered. Further, no cobalt material is contained in the pigment, and even if it is dissolved in an acidic solution such as acid rain, it does not generate and elute hexavalent chromium.

The content of the pigment in the shielding layer forming material can be set as appropriate, but in order to obtain a desired color tone, the content of the pigment in the shielding layer forming material is preferably 0.1 mass% or more, more preferably 1 mass% or more, still more preferably 2 mass% or more, and particularly preferably 5 mass% or more. Further, in order to maintain the sintering property of the shielding layer, the content of the pigment is preferably 50 mass% or less, more preferably 30 mass% or less, still more preferably 25 mass% or less, and particularly preferably 15 mass% or less.

Examples of organic vehicles for dispersing and suspending the above-described frit and pigment include vegetable oils, mineral oils, low molecular-weight petroleum distillates, tridecyl alcohol, synthetic resins, and natural resins.

As the conductive metal, for example, silver (silver particles) can be used.

As the reducing agent, for example, silicon metal can be used.

When an inert particulate inorganic pigment is used, the dispersive surfactant has a function for assisting the pigment in getting wet. In general, the dispersive surfactant contains a block copolymer including a group having an affinity for the pigment, and if necessary, contains a solvent (e.g., xylene, butyl acetate, methoxypropyl acetate). As the dispersive surfactant, known ones can be used. For example, Disperbyk 162 (product name, manufactured by BykChemie) can be used.

The fluid-type modifier is used to adjust the viscosity, and any conventionally known ones can be used as appropriate. For example, Viscobyk series (manufactured by BykChemie) can be used.

The fluid-type auxiliary agent is an additive used to adjust viscosity and flowability, and any conventionally known ones can be used. For example, Additol VXW 6388 (product name, manufactured by UCB Surface Speciality) can be used.

The adhesion promoter is used to improve compatibility with the layer (coating film) on which the shielding layer is provided, and can be selected as appropriate according to the composition of the used coating film.

As the stabilizer, for example, a light stabilizer or a UV shielding agent can be used.

Note that the amounts of these additives to be mixed can be set as appropriate and are not limited to any particular values.

The composition of the shielding layer (the entire shielding layer including the frit, the pigment, the additive, and the like) may be, for example, the below-shown composition, in which the components are shown by mass% based on the oxide. Note that the composition of the shielding layer may be considered to be the same as that of the shielding layer forming material which has not been fired yet.
Bi₂O₃: 35 to 60 mass%,
SiO₂: 15 to 30 mass%,
Cr₂O₃: 5 to 25 mass%,
CuO: 3 to 9 mass%,
MnO₂: 3 to 6 mass%,
Al₂O₃: 0.2 to 4 mass%,
MgO: 0 to 2 mass%,
CaO: 0 to 3 mass%,
BaO: 0 to 8 mass%,
Na₂O: 0 to 5 mass%,
K₂O: 0 to 3 mass%,
TiO₂: 0 to 5 mass%, and
ZnO: 0 to 8 mass%.

The thickness of the shielding layer affects the ultraviolet transmittance, the acid resistance, the weatherability, the concealability, the glass strength, and the cost. In view of the ultraviolet transmittance, the acid resistance, the weatherability, and the concealability, the thickness of the shielding layer is preferably 5 µm or larger, more preferably 8 µm or larger, and still more preferably 10 µm or larger. Further, in view of the glass strength and the cost, the thickness of the shielding layer is preferably 30 µm or smaller, and more preferably 20 µm or smaller. The thickness of the shielding layer can be specified by using a scanning electron microscope (SEM).

The firing conditions of the shielding layer can be set as appropriate within a range in which the effects of the present disclosure can be obtained. For example, the firing speed (conveyance speed) (mm/s) and the firing temperature (°C) when the object to be processed (to which the shielding layer forming material is provided) is conveyed in an automobile glass molding process can be adjusted. Further, when the firing temperature is changed during the firing, the temperature profile thereof and the like can be adjusted. For example, the firing time can be set to 3 to 30 minutes (preferably 4 to 20 minutes), and the firing temperature can be set to 550 to 730°C (preferably 580 to 710°C, and more preferably 600 to 710°C).

### <Method of Manufacturing Glass Article>

In a method for manufacturing a glass article according to the present disclosure (hereinafter, also referred to as "the present manufacturing method"), a functional layer and a silicon oxide-containing layer are formed on a glass substrate in this order by dry coating. Then, the total amount of Ar in the silicon oxide-containing layer is adjusted to 52.0 nm·atomic% or less. Since the total amount of Ar is the same as that described above, the description thereof will be omitted.

The dry coating includes physical vapor deposition (PVD: Physical Vapor Deposition), which is a physical film formation method including vacuum deposition and sputtering, and chemical vapor deposition (CVD: Chemical Vapor Deposition), which is a chemical film formation method.

The PVD method is a method in which a film forming material of which a thin film is eventually formed is vaporized and scattered into a state of particles (atoms and molecules) by heating, sputtering, ion beam irradiation, laser irradiation, or the like, mainly in a state of high vacuum (10⁻¹ to 10⁻⁵ Pa), and then the vaporized and scattered material is made to adhere to and deposited on the surface of the substrate.

The vacuum deposition is a technology in which a thin film is formed by heating, melting, vaporizing or sublimating a film forming material such as a metal or a metal oxide in a vacuum, and then making vaporized or sublimated particles (atoms and molecules) adhere to and deposit on the surface of the substrate.

Further, the sputtering is a technology in which a thin film is formed by feeding an inert gas and a reactive gas (mainly, Ar, O2 and N2) in a vacuum, applying a negative voltage to a target (e.g., a plate-like film forming material) and thereby generating a glow discharge, ionizing inert gas atoms, making gas ions violently collide and hit against the surface of the target at a high speed, making particles (atoms and molecules) of the film forming material of which the target is formed to be ejected therefrom, and making the ejected particles adhere to and deposit on the surface of the substrate with great force. In the sputtering method, a film can be formed even with a material with which it is difficult to form a film by the vacuum deposition method, such as a metal or an alloy having a high melting point, so that a wide range of film forming materials can be used.

Meanwhile, the CVD method is a method in which: a gaseous raw material is fed in a state where the pressure is between the atmospheric pressure and a medium vacuum (100 to 10⁻¹ Pa); a chemical reaction is excited and accelerated by supplying energy such as heat, plasma, and light, and a thin film or fine particles are thereby synthesized; and the thin film or fine particles are made to adhere (adsorb) to and deposited on the surface of the substrate.

As the dry coating film, a film selected from a heat-ray reflection coating film, a low-emissivity coating film (Low-E film), a low-reflection coating film, and a p-polarization reflection coating film can be used. Among these, in order to make better use of the excellent effects of the present disclosure, a low-emissivity coating film and a p-polarization reflection coating film are preferably used, and more preferably, a low-emissivity coating film is used. As the method for forming these films, known methods can be used as appropriate.

The manufacturing method according to the present disclosure is not limited to any particular methods. However, the manufacturing method can include, for example, the following steps.
- A step of preparing a glass substrate (substrate preparation step).
- A step of forming a functional layer on the glass substrate (functional layer forming step).
- A step of forming a silicon oxide-containing layer on the functional layer (silicon oxide-containing layer forming step).

Further, the substrate preparation step (substrate manufacturing step) may include a step of melting a glass raw material and pouring the molten material into a tin bath (melting step), and a step of slowly cooling the molten glass raw material (slow cooling step). Further, when a dielectric layer is provided between the glass substrate and the functional layer, a step of forming a dielectric layer on the glass substrate (dielectric layer forming step) may be performed between the substrate preparation step and the functional layer forming step.

Note that when each of the dielectric layer, the functional layer, and the silicon oxide-containing layer is formed of a plurality of layers, a step of forming each layer may be provided.

Further, in a glass article obtained by the manufacturing method according to the present disclosure, a shielding layer may be formed on the silicon oxide-containing layer (shielding layer forming step), and by doing so, a glass article having the shielding layer may be manufactured (method for manufacturing a glass article including a shielding layer).

The shielding layer forming step may include, for example, the following steps.
- A step of preparing a shielding layer forming material (shielding layer forming material preparing step).
- A step of applying the shielding layer forming material onto the silicon oxide-containing layer (coating step).
- A step of sintering the shielding layer forming material applied onto the silicon oxide-containing layer (sintering step).

Further, the manufacturing method according to the present disclosure may include the following steps.
- A step of heating and molding the glass substrate on which the optional dielectric layer, the functional layer, the silicon oxide-containing layer, and the optional shielding layer are provided in this order into a desired shape (heating and molding step).
- A step of cooling the heated and molded glass substrate (cooling step).

These steps may be successively performed, or a plurality of steps (e.g., the shielding layer forming step (specifically, the sintering step) and the hating and molding step) may be performed in parallel to each other.

The manufacturing method according to the present disclosure will be described hereinafter in detail.

Firstly, for example, a rectangular glass substrate (glass plate) is prepared (substrate preparation step). In this process, a commercially available glass substrate may be purchased and used. Alternatively, a glass substrate can be manufactured by, for example, the following method. That is, glass raw materials mixed to obtain a desired glass composition is heated at a predetermined temperature, and molten glass is thereby obtained. Next, the obtained molten glass is poured into a tin bath filled with molten tin (melting step), and a plate-like glass ribbon is molded and slowly cooled (a slow cooling step), so that a glass substrate is obtained. In this process, the obtained glass ribbon may be subjected to additional processes (e.g., SO₂ treatment and cleaning process). Note that the glass substrate can be molded in any of the above-described melting step and the slow cooling step. Further, when a glass substrate is manufactured, it can be cut into a desired size. For example, when a glass for vehicle is used as a windshield for automobile, a glass substrate having a size of (500 to 1,300 mm) × (1,200 to 1,700 mm) × (1.6 to 2.5 mm) is prepared. The glass substrate may consist of one sheet or may be a laminated glass in which two or more glass sheets are bonded to one another.

Next, coating films are formed in the order of a dielectric layer, a functional layer, and a silicon oxide-containing layer on at least a part of one of the surfaces of the glass substrate, for example, over the entire surface of one of the surfaces of the glass substrate. The conditions for forming these coating films can be selected as appropriate. For example, when a low-emissivity coating film (Low-E film) is formed as a coating film, it is formed by sputtering by using an Ar gas, an O₂ gas, an N₂ gas, or a mixed gas thereof as the process gas.

Note that in order to increase the film density of the silicon oxide-containing layer to be formed and thereby to easily suppress the total amount of Ar and the total amount of H in the silicon oxide-containing layer to the above-described predetermined ranges, the conditions for forming the silicon oxide-containing layer are preferably as follows.

The power density when the silicon oxide-containing layer (e.g., SiOx layer) is sputtered is preferably 7.5 W/cm² or higher, more preferably 8.7 W/cm² or higher, and still more preferably 8.8 W/cm² or higher. Further, from the same point of view, the power density is preferably 9.6 W/cm² or lower, more preferably 9.4 W/cm² or lower, and still more preferably 9.0 W/cm² or lower. Note that in the case of a rectangular target, the power density is obtained by dividing the power by the area (i.e., the size) of the target, and in the case of a cylindrical target, it is obtained by dividing the power by a value expressed by "Length×Diameter×Circular constant/3".

Note that in the case where the silicon oxide-containing layer is a SiOx layer doped with another element(s) (e.g., Zr), from the same point of view, the power density is preferably 7.7 W/cm² or higher, and more preferably 8.0 W/cm² or higher. Further, from the same point of view, the power density is preferably 10.2 W/cm² or lower, more preferably 9.4 W/cm² or lower, and still more preferably 9.2 W/cm² or lower.

From the above-described point of view, the process gas pressure when the silicon oxide-containing layer (doped or non-doped SiOx layer) is sputtered is preferably 1.0 mTorr or higher. Further, in view of the heat resistance, the process gas pressure when the silicon oxide-containing layer (e.g., SiOx layer) is sputtered is preferably 3.0 mTorr or lower, more preferably 2.5 mTorr or lower, and still more preferably 2.0 mTorr or lower. Note that in the case where the silicon oxide-containing layer is a SiOx layer doped with another element(s) (e.g., Zr), from the same point of view, the process gas pressure is preferably 3.0 mTorr or lower, more preferably 2.8 mT or lower, and still more preferably 2.5 mTorr or lower. In this way, a low-emissivity coating film having a satisfactory sheet resistance (Ω/□) can be obtained after the firing.

From the above-described point of view, the average blending ratio of O₂ in the process gas when the silicon oxide-containing layer (e.g., SiOx layer) is sputtered is preferably 80 vol% or higher, and more preferably 90 vol% or higher. Further, the average blending ratio of O₂ may be 100 vol%, and even in this case, the formation of voids can be suppressed, thus making it possible to provide a glass article having an excellent anti-whitening property. Note that in the case where the silicon oxide-containing layer is a SiOx layer doped with another element(s) (e.g., Zr), from the above-described point of view, the average blending ratio of O₂ in the process gas is preferably 38 vol% or higher, and more preferably 50 vol% or higher. Further, from the same point of view, the average blending ratio of O₂ is preferably 90 vol% or lower, and more preferably 85 vol% or lower.

By the above-described conditions and the like, it is possible to obtain a glass article in which a dielectric layer, a functional layer, and a silicon oxide-containing layer are provided on a glass substrate in this order. Note that the dielectric layer may or may not be formed.

Further, for the obtained glass article, a frame-shaped shielding layer can be formed on at least a part (of the uppermost layer) of the silicon oxide-containing layer, for example, on the peripheral edge of the silicon oxide-containing layer (shielding layer forming step). Specifically, a shielding layer forming material (e.g., ceramic color paste) is applied to at least a part of the area of the glass substrate in which the dielectric layer, the functional layer, and the silicon oxide-containing layer are formed in this order (coating step), and if necessary, the applied shielding layer forming material is dried. The method for applying a shielding layer forming material is not limited to any particular methods. For example, a screen-printing method, an ink jet method, electronic printing, or the like can be used. Specifically, it is preferred to print a shielding layer forming material on the glass substrate with a #150 to #250 mesh screen.

Note that for the shielding layer forming material, a commercially available product may be used, or the shielding layer forming material may be separately prepared (shielding layer forming material preparation step). The shielding layer forming material can be prepared, for example, by dispersing the above-described desired frit and pigment in an organic vehicle.

Next, the obtained glass substrate is heated to a predetermined temperature by using, for example, a firing furnace such as a transportable IR furnace, and the shielding layer forming material is thereby sintered on the glass substrate (sintering step). The heating (firing) temperature is not limited to any particular temperatures. For example, the heating temperature is 500 to 730°C (preferably 550 to 700°C). Further, the firing speed (conveyance speed) is also not limited to any particular speeds, and is preferably 5 to 30 mm/s. Further, the heating time is, for example, 3 to 30 minutes (preferably 4 to 20 minutes). Through the above-described processes, a shielding layer is formed on the glass substrate.

Note that since the glass frit contained in the shielding layer forming material exhibits various characteristics, one type of frit may be used or two or more type(s) of frit(s) may be used in a mixed manner. Further, two or more type(s) of frit(s) that have the same composition but have different particle sizes may be used as appropriate in a mixed manner. The melting point of the frit is preferably 600°C or higher and more preferably 630°C or higher in order to reduce the porosity. Further, the melting point of the frit is preferably 700°C or lower and more preferably 680°C or lower in view of the adhesion to the glass.

When two or more type(s) of frit(s) are used in a mixed manner, it is preferred that among them, one or more type(s) of frit(s) have a softening point within the above-described range, and it is more preferred that all the frits have a softening point within the above-described range.

Next, the glass substrate on which the coating film and the shielding layer are provided in this order is heated and molded into a desired shape (heating and molding step), and if necessary, a cooling operation is performed (cooling step). Note that the glass substrate may be molded into a desired shape by performing self-weight bending or press bending in a state where the glass substrate is held at the heating temperature in the above-described sintering step. That is, the heating and molding step and the sintering step may be performed in parallel to each other.

In the press bending, for example, the glass plate is bent by a press apparatus (heating press apparatus) according to the desired shape of the window glass for automobile. In the self-weight bending, the glass substrate is bent by a self-weight bending apparatus. Further, air-cooling strengthening or the like may be performed according to the safety standards required for the window glass for automobile.

The glass article according to the present disclosure obtained as described above has excellent durability and an excellent external appearance, and of which the occurrence of whitening can be suppressed.

### Examples

The present invention will be described hereinafter in a more detailed manner by using a plurality of examples, but the present disclosure is not limited to these examples. Note that Examples 1 to 6 are examples for glass articles according to the present disclosure, and Examples 7 and 8 are comparative examples.

### [Example 1]

### (Preparation of Glass Substrate and Manufacturing of Coating Film)

A low-emissivity coating film was formed on one of the surfaces of a glass substrate by using a sputtering apparatus. Specifically, first, a glass substrate having a thickness of 2.1 mm (Product Name: FGY 1, manufactured by AGC Inc.) was prepared.

Next, a titanium oxide layer containing zirconia was formed as a first dielectric layer on the surface of this glass substrate by a sputtering method. A zirconia-doped titania target containing 35 mass% of zirconia was used for the film formation, and the film thickness was 10 nm according to an optical simulation based on spectroscopic measurement.

Next, a silicon oxide layer was formed as a second dielectric layer by a sputtering method. The film thickness was 35 nm according to an optical simulation based on spectroscopic measurement.

Next, an ITO (indium tin oxide) layer was formed as a functional layer by a sputtering method. The film was formed by using a tin oxide-doped indium oxide target containing 10 mass% of tin oxide and a mixed gas of which the average oxygen blending ratio O₂/(O₂+Ar) was 0.2 volume%. The film thickness was 120 nm according to an optical simulation based on spectroscopic measurement.

Next, a first silicon oxide-containing layer (SiOx) was formed. The film was formed by using a silicon target and a mixed gas of which the average oxygen blending ratio O₂/(O₂+Ar) was 80 volume% and applying power of 48.9 kW (power density: 9.6 W/cm²) under a pressure of 2.0 mTorr. The film thickness was 80 nm according to an optical simulation based on spectroscopic measurement.

Next, a silicon oxide-containing layer (SiOx: Zr) containing zirconia was formed as a second silicon oxide-containing layer on the surface of the obtained glass substrate by a sputtering method. The film was formed by using a zirconia-doped silica target containing 10 mass% of zirconia and a mixed gas of which the average oxygen blending ratio O_{2/}(O₂+Ar) was 52 volume%, and applying power of 48.0 kW (power density: 9.4 W/cm²) under a pressure of 3.0 mTorr. The film thickness was 25 nm according to an optical simulation based on spectroscopic measurement.

Through the above-described steps, a glass substrate with a coating film was obtained. Note that when these layers were formed, Ar, O₂, or a mixed gas thereof was used unless otherwise specified. For the obtained glass articles, various physical properties described later were measured, and they were also evaluated based on evaluation methods described later.

### [Examples 2, 3, 5, 7 and 8]

In each of Examples 2, 3, 5, 7 and 8, the power, the power density, the process gas pressure, and the average oxygen blending ratio for sputtering the first and second silicon oxide-containing layers were adjusted as shown in Table 1. The other conditions and the like were the same as those in Example 1. Then, in each of the example, a glass article including a coating film was manufactured, and various physical properties described later were measured, and they were also evaluated based on evaluation methods described later.

### [Example 4]

A glass article including a coating film was manufactured in the same manner as in Example 1 except that the first and second silicon oxide-containing layers were respectively formed according to methods described below. Then, various physical properties described later were measured, and they were also evaluated based on evaluation methods described later.

That is, a film of the first silicon oxide-containing layer was formed by using a silicon target and a gas having an average oxygen blending ratio of O₂100 vol%, and applying power of 45.0 kW (power density: 8.8 W/cm²) under a pressure of 2.0 mTorr. The film thickness was 46 nm according to an optical simulation based on spectroscopic measurement.

Next, a film of the second silicon oxide-containing layer was formed by using a silicon target and a mixed gas having an average oxygen blending ratio O₂/(O₂+Ar) of 80 vol%, and applying power of 45.0 kW (power density: 8.8 W/cm²) under a pressure of 2.0 mTorr. The film thickness was 46 nm according to an optical simulation based on spectroscopic measurement.

### [Example 6]

A glass article including a coating film was manufactured in the same manner as in Example 1 except that the first silicon oxide-containing layer was formed a method described below without forming the second silicon oxide-containing layer. Then, various physical properties described later were measured, and they were also evaluated based on evaluation methods described later.

That is, a film of the first silicon oxide-containing layer was formed by using a silicon target and a gas having an average oxygen blending ratio of O₂100 vol%, and applying power of 45.0 kW (power density: 8.8 W/cm²) under a pressure of 2.0 mTorr. The film thickness was 92 nm according to an optical simulation based on spectroscopic measurement.

### (Method for Measuring Physical Property)

The method for measuring physical property values of the obtained glass articles was as follows.

### [Total Amount of Ar in Silicon Oxide-Containing Layer]

For each example, the total amount of Ar (nm·atomic%) in the silicon oxide-containing layer (the first and second silicon oxide-containing layers for the examples except Example 6, and the first silicon oxide-containing layer for Example 6) of the obtained glass article was determined according to a method described below.

The average Ar atomic concentration in each silicon oxide-containing layer was calculated by steps (I) and (II) described below.
I) A composition depth profile including an Ar atomic concentration [atomic%] in a silicon oxide-containing film was obtained by simulation fitting by using values which were detected by applying He⁺⁺ ions of 2,300 keV under two conditions, i.e., two incident angles of 0° and -35°, by a Rutherford scattering spectrum analyzer (Pelletron 3SDH (Product Name) manufactured by National Electrostatics Corporation). Note that one step of the depth profile was in a range of 1 to 3 nm.
II) In the Ar atomic concentration depth profile in the silicon oxide-containing film, a part where three consecutive measurement points fell within an area of average values of ±0.05 atomic% was defined as a flat part in which the Ar atomic concentration was read. When there were a plurality of consecutive measurement points which fell within the range of average values ±0.05 atomic%, an average value of all of these measurement points was defined as an average Ar atomic concentration of the layer. Note that when there were a plurality of discontinuous flat parts in one layer, for each of these flat parts, a value was calculated by multiplying the above-described average Ar atomic concentration by the film thickness with which the average value was calculated, and then a value obtained by dividing the sum total of these calculated values by the total thickness of all the flat parts was defined as the average Ar atomic concentration of the layer. When the average Ar atomic concentration was the detection limit of 0.1 atomic% or lower, 0.05 atomic% was defined as the average Ar atomic concentration of the layer. In a profile of an element the amount of which was the largest among the elements that were not present in the silicon oxide-containing film among the layers adjacent to the silicon oxide-containing film in the atomic concentration depth profile, a part where the atomic concentration of the element in a flat part nearest to the silicon oxide-containing film had a half value was defined as the boundary of the silicon oxide-containing layer for the flat part in which the value or the like was read in order to calculate the Ar atomic concentration. When there was no flat part, a place at which the maximum atomic concentration of the aforementioned element had a half value was defined as the boundary of the two layers, and the average Ar atomic concentration in the boundary was calculated.

A value obtained by multiplying the obtained average Ar atomic concentration by the thickness of the silicon oxide-containing layer was calculated as the amount of Ar [nm·atomic%]. When the silicon oxide-containing layer was a single layer, the value obtained by the above-described calculation was used as the total amount of Ar. Meanwhile, when there were a plurality of silicon oxide-containing layers, the sum total of amounts of Ar in these layers was defined as the total amount of Ar.

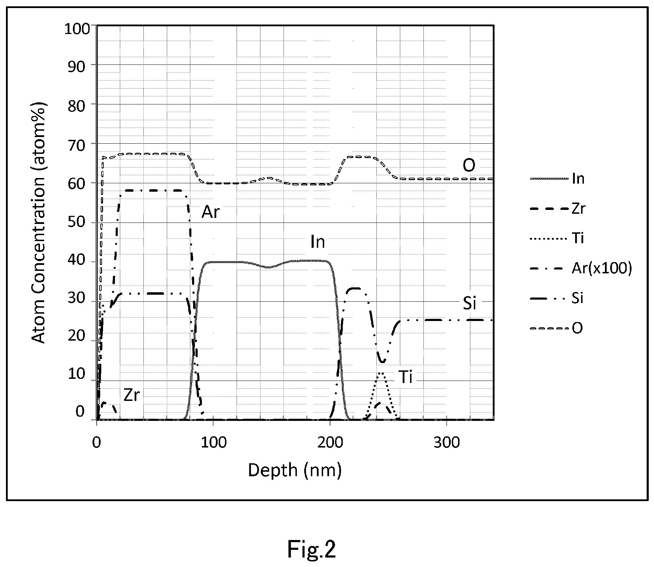

Note that Fig. 2 shows profiles of concentrations of various atoms in the depth direction measured by using a Rutherford scattering spectrum analyzer (RBS) in Example 1. As described above, it is possible to obtain the composition ratio of each silicon oxide-containing layer in the depth direction and the average Ar atomic concentration thereof by using an RBS.

### [Total Amount of H in Silicon Oxide-Containing Layer]

For each example, the total amount of H (nm/cm³) in the silicon oxide-containing layer (the first and second silicon oxide-containing layers for the examples except Example 6, and the first silicon oxide-containing layer for Example 6) of the obtained glass article was determined according to steps (I) to (III) described below.
(I) An ultraviolet (UV) ozone treatment was carried out in order to remove organic contaminations from the surface of the sample to be measured (silicon oxide-containing layer). For the UV ozone treatment, an ultraviolet irradiation apparatus, Product Name: PL30-200 (manufactured by Sen Engineering Co., Ltd.), and an ultraviolet irradiation apparatus power supply, Product Name: UB2001D-20, were used. The conditions for the treatment were as follows: Ultraviolet wavelength: 254 nm, and Treatment time: 10 minutes.
(II) The concentration of H and an average H/Si strength ratio in a standard sample were measured by using an H⁺-implanted silicon oxide having an amount of H⁺ of 1% or less as a standard sample for quantification and using a secondary ion mass spectrometer. The conditions for the analysis are as follows.
   Apparatus: Product Name: PHI ADEPT 1010 manufactured by ULVAC-PHI, INCORPORATED,
   Primary ion species: Cs⁺,
   Primary ion acceleration voltage: 2 kV,
   Primary ion current: 20 nA,
   Primary ion incident angle (angle measured from the direction perpendicular to the surface of the sample): 60°,
   Raster size: 400 × 400 µm², and
   Secondary ion polarity: Negative.
(III) The average H/Si strength ratio in the sample to be measured was measured by using a secondary ion mass spectrometer under the same analysis conditions as those described above. Then, the relative sensitivity coefficient of the above-described standard sample for quantification was calculated according to JISK 0163: 2010, and the average H/Si strength ratio in the sample to be measured was converted into the concentration of H. A value obtained by multiplying the obtained concentration of H by the thickness of the silicon oxide-containing layer was defined as the amount of H [nm/cm³]. When there were a plurality of silicon oxide-containing layers, the sum total of the amounts of H in all the layers was defined as the total amount of H.

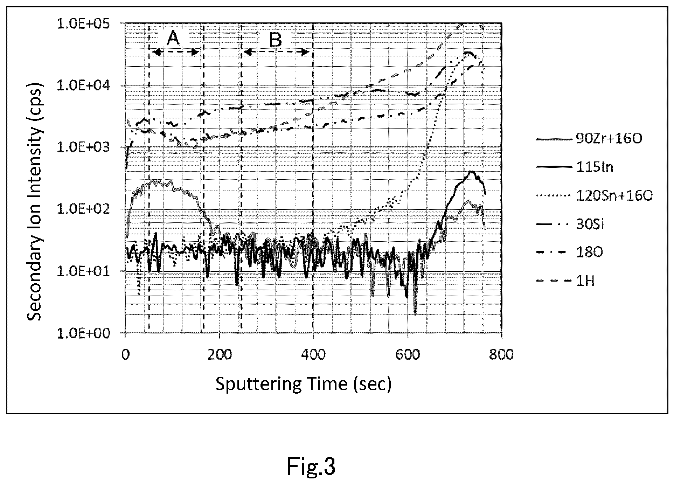

Note that Figs. 3, 4 and 5 show relationships between the secondary ion intensity (cps) of elements constituting samples measured by using the secondary ion mass analyzer and the sputtering times (sec) in Examples 1, 7 and 6, respectively.

Note that the range in which the H/Si strength ratio was calculated was defined based on the profile of a metal element having the largest intensity change among metal elements that were not present in adjacent layers. Specifically, as shown in Fig. 3, in which the profile of Example 1 is shown, when the (90Zr+16O) - secondary ion profile in the silicon oxide-containing layer containing zirconia as the outermost layer has a flat area, the H/Si strength ratio in the leveled-off stagnation area from the end of the sharp rise in the (90Zr+16O) - secondary ion intensity to the point where the intensity starts to sharply drops was defined as the H/Si strength ratio of the layer. Specifically, for the silicon oxide-containing layer containing zirconia, the H/Si strength ratio in the range indicated by a symbol A in Fig. 3 was defined as the H/Si strength ratio of the silicon oxide-containing layer. Further, for the subsequent silicon oxide-containing layer containing no metal element other than Si as a main metal element, the H/Si strength ratio in the area from the end of the sharp drop in the (90Zr+16O) - secondary ion intensity to the point where the (120Sn+16O) - secondary ion intensity starts to rise (range indicated by a symbol B in Fig. 3) was defined as the H/Si strength ratio of the silicon oxide-containing layer.

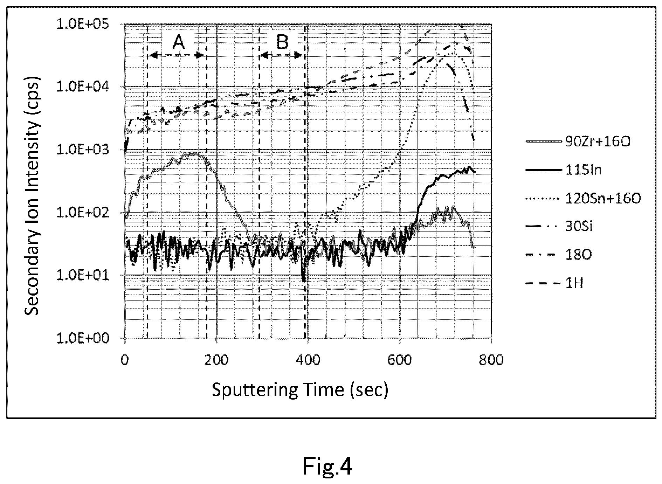

As shown in Fig. 4, in which the profile of Example 7 is shown, when there is no leveled-off stagnant area in the (90Zr+16O) - secondary ion intensity profile in the outermost zircon-doped silicon oxide-containing layer in the silicon oxide-containing layer containing zirconia, the H/Si strength ratio in the area from the end of the sharp rise in the (90Zr+16O) - secondary ion intensity to the point where the intensity starts to sharply drop (range indicated by a symbol A in Fig. 4) was defined as the H/Si strength ratio of the Zr-doped silicon oxide-containing layer. For the subsequent silicon oxide-containing layer containing no metal element other than Si as a main metal element, the H/Si strength ratio in the range indicated by a symbol B in Fig. 4 was calculated in the same manner as in Example 1.

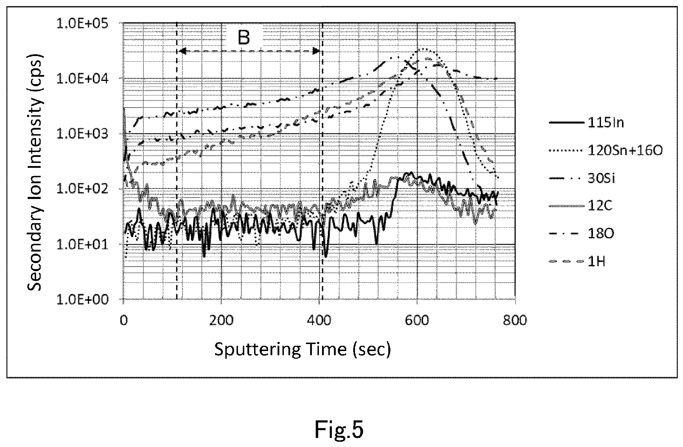

As shown in Fig. 5, in which the profile of Example 6 is shown, when the silicon oxide layer containing no metal element other than Si as a main metal element is the outermost layer, the H/Si strength ratio in the area from the end of the sharp rise in the 30Si - secondary ion intensity to the point where the (120Sn+16O) - secondary ion intensity starts to rise (range indicated by a symbol B in Fig. 5) was defined as the H/Si strength ratio of the layer.

Note that for each sample to be measured, the H/Si strength ratio was calculated three times, and the average value of these ratios was defined as the average H/Si strength ratio.

Note that in Table 1, for example, the total amount of H [nm/cm³] "5.63 E+23" in Example 1 means "5.63 × 10²³".

### [Sheet Resistance]

The temperature of each of the above-described glass substrates was raised at 3°C/second up to the firing temperature of 650°C by using a firing furnace (IR furnace), and the firing temperature was maintained after the temperature reached the firing temperature. Further, the total firing (heating) time was 240 seconds. The sheet resistance of the glass substrate after the firing was measured by using a non-contact surface resistance measuring device (PULS manufactured by NAGY). Table 1 shows the results of the measurement.

### <Evaluation Method>

The obtained glass articles were evaluated by the following evaluation method.

### [Evaluation of Anti-whitening Property]

Each of Shielding layers A and B having respective elemental compositions (mass%) shown in Table 2 was manufactured on respective glass substrates each having the above-described structure, specifically on the peripheral edges of the coating films (uppermost silicon oxide-containing layer) of the respective glass substrates. Specifically, for each layer, a shielding layer forming material having the aforementioned elemental composition was printed on the peripheral edge of the coating film by a screen printing method by using a screen of #150 to #250 mesh, and then was dried. Next, the shielding layer forming material was sintered on the glass substrate under the below-shown firing conditions by using a firing furnace (IR furnace), and each of frame-shaped shielding layers A and B as shown in Fig. 1 C was thereby formed. The thicknesses of the shielding layers were both 15 µm. Note that when each of the shielding layers A and B was sintered on the respective glass substrate, bending was also performed, so that a window glass for automobile having a curved shape (glass article) was manufactured. In this way, glass articles in each of which a coating film and the shielding layer A or B were laminated in this order on the glass substrate were manufactured.

### - Firing Condition

Firing temperature: 650, 660°C, or 670°C.
Temperature rising condition: The temperature was raised at 3°C/second up to the firing temperature (650 to 670°C), and the firing temperature was maintained after the temperature reached the firing temperature. Further, the total firing (heating) time was 240 seconds.

Note that the specific elemental composition (mass%) of the shielding layer A shown in Table 2 was as shown below. Note that the method for determining the composition of the shielding layer will be described later. Bi: 36.1, Si: 8.2, O: 29.1, Cr: 12.4, Cu: 5.5, Mn: 4.0, Na: 1.2, Al: 0.6, Ti: 0.4, K: 0.2, and C: 2.3 (Total 100).

Further, the specific elemental composition (mass%) of the shielding layer B shown in Table 2 was as follows. Bi: 29.7, Si: 9.1, O: 33.1, Cr: 12.1, Cu: 6.0, Mn: 3.9, Na: 1.4, Al: 0.6, Ti: 0.9, K: 0.4, and C: 2.9 (Total 100).

The whitening levels of the obtained glass articles (two types of glass articles to which the shielding layers A and B were respectively applied for each example) were visually checked and evaluated based on the below-shown evaluation criteria. Table 1 shows the results of the evaluations.

### - Evaluation Criterion

AA: The color of the manufactured shielding layer was black and the desired external appearance was obtained under all the temperature conditions of the firing temperatures from 650°C to 670°C.
A: The color of the shielding layer was black and the desired external appearance was obtained at both the firing temperature of 650°C and 660°C. However, the color of the shielding layer was gray and the desired external appearance was not obtained at the firing temperature of 670°C.
B: The color of the shielding layer was black and the desired external appearance was obtained at the firing temperature of 650°C. However, the color of the shielding layer was gray and the desired external appearance was not obtained at both the firing temperature of 660°C and 670°C.
C: The color of the manufactured shielding layer was gray and the desired external appearance was not obtained under all the temperature conditions of the firing temperatures from 650°C to 670°C.

### [Composition of Shielding Layer]

The elemental compositions of the shielding layers A and B used for the glass articles in the above-described evaluations of the anti-whitening property were determined by the following method. That is, the surface of the sample (shielding layer) was measured by energy dispersive X-ray spectroscopy (SEM-EDX), and the composition (mass%) of each component (element) was quantified. In the above-described process, Product Name: TM4000Plus manufactured by Hitachi, Ltd. was used as a scanning electron microscope (SEM), and Product Name: AZtecOne manufactured by Oxford Instruments was used as EDX. Table 2 shows the results of the measurement.

### [Content of SiO₂]

The contents of SiO₂ (mass%) in the shielding layers A and B used for the glass articles in the above-described evaluations of the anti-whitening property were measured by SEM-EDX. Table 2 shows the results of the measurement.

### [Bi/Si Ratio]

The Bi/Si mass% ratio in each of the shielding layers A and B was calculated based on the composition of the shielding layer specified by the above-described SEM-EDX. Table 2 shows the results of the measurement.

### [Table 1]

**Table 1**

| | **Silicon Oxide-containing Layer** | | | | | | | | | | **Total Amount of Ar [nm· atomic%]** | **Total Amount of Ar [nm]** | **Total Amount of H [nm/cm³]** | **Sheet Resistance [Ω/□]** | **Evaluation of Anti-Whitening Property** | |
|---|---|---|---|---|---|---|---|---|---|---|---|---|---|---|---|---|
| | **SiOx** | | | | | **SiOx:Zr** | | | | | | | | | | |
| | **Power [kW]** | **Power Density [W/cm²]** | **Pressure [mTorr]** | **O₂/(Ar+O₂) [Volume%]** | **Film Thickness [nm]** | **Power [kW]** | **Power Density [W/cm²]** | **Pressure [mTorr]** | **O₂/(Ar+O₂) [Volume%]** | **Film Thickness [nm]** | | | | | **Shielding Layer A** | **Shielding Layer B** |
| **Example 1** | **48.9** | **9.6** | **2.0** | **80** | **80** | **48.0** | **9.4** | **3.0** | **52** | **25** | **51.5** | **0.515** | **5.63E+23** | **15.0** | **B** | **A** |
| **Example 2** | **38.6** | **7.6** | **2.0** | **70** | **80** | **40.5** | **8.0** | **3.0** | **50** | **25** | **33.5** | **0.335** | **5.15E+23** | **15.9** | **B** | **A** |
| **Example 3** | **44.4** | **8.7** | **2.0** | **70** | **80** | **52.0** | **10.2** | **3.0** | **50** | **25** | **38.0** | **0.380** | **1.82E+23** | **14.0** | **A** | **AA** |
| **Example 4** | **45.0** | **8.8** | **2.0** | **100/80(50%)** | **92** | **-** | **-** | **-** | **-** | **-** | **23.4** | **0.234** | **2.50E+23** | **15.1** | **A** | **AA** |
| **Example 5** | **38.3** | **7.5** | **2.0** | **70** | **80** | **39.0** | **7.7** | **3.0** | **38** | **25** | **18.5** | **0.185** | **1.93E+23** | **14.1** | **AA** | **AA** |
| **Example 6** | **45.0** | **8.8** | **2.0** | **100** | **92** | **-** | **-** | **-** | **-** | **-** | **17.1** | **0.171** | **2.88E+23** | **14.9** | **AA** | **AA** |
| **Example 7** | **40.5** | **8.0** | **2.0** | **85** | **80** | **47.3** | **9.3** | **3.0** | **50** | **25** | **55.0** | **0.550** | **5.59E+23** | **13.6** | **C** | **B** |
| **Example 8** | **48.9** | **9.6** | **2.0** | **80** | **80** | **48.0** | **9.4** | **3.0** | **52** | **25** | **66.0** | **0.660** | **4.52E+23** | **15.0** | **C** | **c** |

### [Table 2]

**Table 2**

| | | **Element (mass%)** | | | | **Bi/Si (mass% ratio)** | **Content of SiO₂ (mass%)** |
|---|---|---|---|---|---|---|---|
| | | **Bi** | **Si** | **Others** | **Total** | | |
| **Type of Shielding Layer** | **A** | **36.1** | **8.2** | **55.7** | **100** | **4.4** | **19.2** |
| | **B** | **29.7** | **9.1** | **61.2** | **100** | **3.3** | **22.3** |

As described above, it can be understood that a glass article according to the present disclosure including a silicon oxide-containing layer having a specific total amount Ar has, irrespective of the type of used shielding layer, an excellent anti-whitening property and an excellent external appearance, and of which the occurrence of whitening caused by voids can be suppressed.

This application is based upon and claims the benefit of priorities from Japanese patent application No. 2022-199456, filed on December 14, 2022, and Japanese patent application No. 2023-019959, filed on February 13, 2023, the disclosure of which is incorporated herein in their entirety by reference.

### Reference Signs List

- 1: GLASS SUBSTRATE
- 2: DIELECTRIC LAYER
- 3: FUNCTIONAL LAYER
- 4: SILICON OXIDE-CONTAINING LAYER
- 5: SHIELDING LAYER

## Claims

1. A glass article comprising, on a glass substrate, a functional layer and a silicon oxide-containing layer in this order, wherein
a total amount of Ar in the silicon oxide-containing layer is 52.0 nm·atomic% or less.

2. The glass article according to claim 1, wherein the total amount of Ar in the silicon oxide-containing layer is 19.0 nm·atomic% or less.

3. The glass article according to claim 1, wherein a total amount of H in the silicon oxide-containing layer is 5.7×10²³ nm/cm³ or less.

4. The glass article according to claim 3, wherein the total amount of H in the silicon oxide-containing layer is 2.9×10²³ nm/cm³ or less.

5. The glass article according to claim 1, further comprising a shielding layer on the silicon oxide-containing layer, and
a Bi/Si ratio in the shielding layer is 3.8 or lower.

6. The glass article according to claim 3, further comprising a shielding layer on the silicon oxide-containing layer, and
a Bi/Si ratio in the shielding layer is 3.8 or lower.

7. The glass article according to claim 5, wherein a content of SiO₂ in the shielding layer is 15 mass% or more.

8. The glass article according to claim 1, wherein the silicon oxide-containing layer contains an element selected from Al and Zr.

9. The glass article according to claim 1, further comprising a dielectric layer between the glass substrate and the functional layer, and
the dielectric layer contains an element selected from Si, C, Ti, Zr, Nb, Zn, Sn and Al, or an oxide, a nitride or an oxynitride of these elements.

10. The glass article according to claim 1, wherein the functional layer contains an element selected from In, Sn, Al, Ni, Cr, Zr, Ti, Nb, W, Fe and F, or an oxide, a nitride or an oxynitride of these elements.

11. A glass article according to any one of claims 1 to 10, wherein the glass article is used as a window glass for automobile.

12. A method for manufacturing a glass article, comprising forming, on a glass substrate, a functional layer and a silicon oxide-containing layer in this order by dry coating, wherein
a total amount of Ar in the silicon oxide-containing layer is adjusted to 52.0 nm·atomic% or less.

13. The method for manufacturing a glass article according to claim 12, wherein a power density when the silicon oxide-containing layer is sputtered is 8.7 W/cm² or higher.

14. The method for manufacturing a glass article according to claim 12, wherein a process gas pressure when the silicon oxide-containing layer is sputtered is 3.0 mTorr or lower.

15. The method for manufacturing a glass article according to claim 12, wherein an average blending ratio of O₂ in a process gas when the silicon oxide-containing layer is sputtered is 80 vol% or higher.

16. The method for manufacturing a glass article according to claim 15, wherein an average blending ratio of O₂ in a process gas when the silicon oxide-containing layer is sputtered is 90 vol% or higher.
